# EUROPEAN PATENT APPLICATION

(11) **EP 1 853 095 A1**
(43) Date of publication of application: **07.11.2007**
(21) Application number: 06712245.7
(22) Date of filing: 24.01.2006
(51) Int. Cl.: H05K 1/02, H01B 7/08, H05K 1/18

(54) **THREE-DIMENSIONAL WIRING BODY FOR MOUNTING ELECTRONIC COMPONENT AND ELECTRONIC COMPONENT MOUNTING STRUCTURE**

(30) Priority: 25.01.2005 JP 2005016379
(71) Applicant: The Furukawa Electric Co., Ltd., Chiyoda-ku Tokyo 100-8322 (JP)
(72) Inventor: ENOMOTO, Noritsugu, hi 2-chome, Chiyoda-ku Tokyo, 1008322 (JP); UTSUNOMIYA, Hirofumi, hi 2-chome, Chiyoda-ku Tokyo, 1008322 (JP); KAMIMURA, Ken, hi 2-chome, Chiyoda-ku Tokyo, 1008322 (JP); MOTOMURA, Shigeki, hi 2-chome, Chiyoda-ku Tokyo, 1008322 (JP); AOYAGI, Shigeharu, hi 2-chome, Chiyoda-ku Tokyo, 1008322 (JP); TAKEDA, Junichi, hi 2-chome, Chiyoda-ku Tokyo, 1008322 (JP)
(74) Representative: Zech, Stefan Markus
(86) International application number: PCT/JP2006/301029
(87) International publication number: WO 2006/080298

(57) **Abstract**

A three-dimensional, electronic components mounted wiring body comprises a flat wiring body, on which a plurality of electronic components is mounted, and which is preformed with bends to be configured into a three-dimensional structured flat wiring body which fits the shape of a base structure on which the flat wiring body is to be mounted. An electronic components mounting structure is provided by mounting the three-dimensional, electronic components mounted wiring body on the three-dimensional base structure which is assembled from base members and their joining members. Connectors having piercing members are used to electrically and mechanically connect the electronic components to the flat wiring body.

## Description

### Technical Field

The present invention relates to a three dimensional wiring body for mounting and wiring electronic components for use in vehicles and others as well as an electronic components mounting structure.

### Background Art

In recent years, light emitting diodes (LEDs) have been widely used for lamps on the front and rear of automobiles. An electric wire, bus bar or flat wiring body has been used to form a wiring circuit or power feed circuit for such LEDs. For instance, a light emitting structure in which LEDs that are connected to electric wires are arranged in a three dimension and steps is known (see patent documents D1 and D2). Also known is another light emitting structure in which LEDs that are connected to a flat wiring body are arranged in three dimensional steps (see patent documents D3 to D6).
Patent Document D1: Japanese Patent Application Publication 2000-243110
Patent Document D2: Japanese Patent Application Publication 2002-245812
Paten Document D3: Japanese Patent Application Publication H10-247421
Paten Document D4: Japanese Patent Application Publication 2001-222915
Paten Document D5: Japanese Patent Application Publication 2002-133917
Paten Document D6: Japanese Patent Application Publication 2004-247281

### Summary of the Invention

### Problem to be solved

However, the above mentioned conventional art disclosed in the respective patent documents generally has two problems: The first problem is associated with the operability of the mounting and assembling. In the case of patent documents D1 and D2, the light emitting structure using a wiring circuit in the form of electric wires or bus bars requires time-consuming and troublesome operations for mounting and wiring LEDs on a complicated and integrally formed, three-dimensional base of the structure. Similarly in the case of patent documents D3 to D6, the light emitting structure using a flat wiring body requires time-consuming and troublesome operations for positioning LEDs at respective steps and fixing the flat wiring body. Thus in either case, the mounting cost is increased accordingly.

The second problem is associated with the cost of parts and material. Specifically, the art disclosed in patent documents D1 to D6 uses an integrally fixed base for arranging a plurality of LEDs. Such a base generally serves as the one specialized for an individual particular light emitting structure. Hence, in order for the base to address various kind of the light emitting structure, increased kinds of such bases are required, thus increasing the component and management cost. In addition, the volume of the base tends to be increased for the mounting capability requirement so that the freedom of designing the base is limited.

Therefore, it is an object of the present invention to provide a three-dimensional, electronic components mounted wiring body and an electronic components mounting structure with which mounting operations on the structure can easily and surely be done, and the mounting cost and the material cost are reduced.

### Solution

According to the present invention, a first embodiment of the three-dimensional, electronic components mounted wiring body comprises a flat wiring body, on which a plurality of electronic components is mounted and which is preformed with bends adapted to be shaped into a three-dimensional structured flat wiring body which fits the shape of a base structure on which the flat wiring body is to be mounted.

In a second embodiment of the three-dimensional, electronic components mounted wiring body, the electronic components comprise light emitting diodes.

In a third embodiment of the three-dimensional, electronic components mounted wiring body, a pierce terminal and a feed line are connected to the flat wiring body at a portion thereof so that the piece terminal mechanically and electrically connects the flat wiring body to the feed line.

In a fourth embodiment of the three-dimensional, electronic components mounted wiring body, connectors each having a rear plate and a piercing member are provided to electrically and mechanically connect the electronic components to the flat wiring body.

In a fifth embodiment of the three-dimensional, electronic components mounted wiring body, leads of the electronic component are collectively connected to the rear plate of the connector by means of shear connection.

In a sixth embodiment of the three-dimensional, electronic components mounted wiring body, the flat wiring body is preformed with fold lines at which the wiring body is bent afterward to form bent portions.

According to the present invention, a first embodiment of the electronic components mounting structure comprises a flat wiring body, on which a plurality of electronic components is mounted and which is preformed with bends so as to be configured into a three-dimensional structured flat wiring body which fits the shape of a base structure for mounting the flat wiring body thereon, in which the base structure uses a plurality of base members and their joining members so as to form a three dimensional shape, and in which the three-dimensional structured flat wiring body is mounted on the base structure.

In a second embodiment of the electronic components mounting structure, the base structure is formed with holes at which the electronic components mounted on the flat wiring body are positioned.

A third embodiment of the electronic components mounting structure further comprises a fixing structure which fixes the three-dimensional structured flat wiring body on the base structure.

A fourth embodiment of the electronic components mounting structure further comprises a reflector structure with which the base structure is fit and a fixing structure which is provided in at least one of the reflector structure and the base structure to fix the three-dimensional structured flat wiring body mounted on the base structure when the base structure is fit with the reflector structure.

### Advantage of the Invention

According to the invention, the three-dimensional, electronic components mounted wiring body is comprises a flat wiring body, on which a plurality of electronic components is mounted and which is preformed with bends so as to be shaped into a three-dimensional structured flat wiring body which fits the shape of a base structure on which the flat wiring body is to be mounted. Thus, the present invention reduces the time-consuming operations that are required in the conventional art to individually mount and wire electronic components on the base structure at respective positions which is integrally formed in a complicated three dimension. In addition, the present invention can readily be adapted to a design change of the base structure by simply changing the shape of the three-dimensional structured flat wiring body, thus increasing the freedom of design, and flexible adaptability for the design change.

According to the present invention, the electronic components mounting structure comprises a flat wiring body, on which a plurality of electronic components is mounted and which is preformed with bends so that the flat wiring body is configured into a three-dimensional structured flat wiring body which fits the shape of a base structure for mounting the flat wiring body thereon, in which the base structure uses a plurality of base members and their joining members so as to form a three dimensional shape, and in which the three-dimensional structured flat wiring body is mounted on the base structure. Hence, there is no need for preparing various kinds of base structures according to product kinds as needed in the conventional art, and thus the component cost and the management cost are significantly reduced.

### Brief Description of the Drawings

FIG. 1 is a perspective view of a three-dimensional structured flat wiring body constituting a three-dimensional, electronic components mounted wiring body according to an embodiment of the present invention;
FIG. 2 is a perspective view showing a base structure for use in an electronic components mounting structure according to the embodiment of the present invention;
FIG. 3 is a perspective view showing a reflector structure for use in the electronic components mounting structure according to the embodiment of the present invention;
FIG. 4 is a side view showing an electronic component with connectors;
FIG. 5 is a partial section view illustrating how the electronic component and connectors of FIG. 4 is mounted on the flat wiring body;
FIG. 6 is a perspective view showing a pierce terminal;
FIG. 7 is a perspective view showing a fixing structure for fixing the three-dimensional structured flat wiring body to the base structure;
FIG. 8 is a perspective view illustrating a structure with which the base structure and the reflector cooperate to fix the flat wiring body to the base structure;
FIG. 9 is a side view of the flat wiring body; and
FIG. 10 is a plan view of the flat wiring body.

### Description of Reference Symbols

- 2:: flat wiring body
- 3:: flat conductor
- 4:: insulating coating
- 5:: bend
- 6:: feed line
- 6a:: conductor
- 6b:: insulating coating
- 7:: pierce terminal
- 7a:: rear plate
- 7b:: piercing member
- 7c:: insulation barrel
- 7d:: crimping barrel
- 8:: circuit separator
- 10:: three-dimensional structured flat wiring body
- 20:: electronic component
- 21:: light emitting device
- 22:: lead
- 23:: connector
- 23a:: back plate
- 23b:: piercing member
- 23c:: shear
- 30:: base structure
- 31, 31a, 31b, 31c:: base member
- 32:: joining member
- 33:: hole
- 34:: slit
- 34a:: cutout
- 35 :: locking piece
- 36 :: fitting protrusion
- 40 :: reflector structure
- 41 :: inserting hole
- 42 :: protrusion
- 50 :: fold line

### Best Modes for Carrying out the Invention

The present invention will now be described with respect to an embodiment thereof taken in conjunction with the drawings.

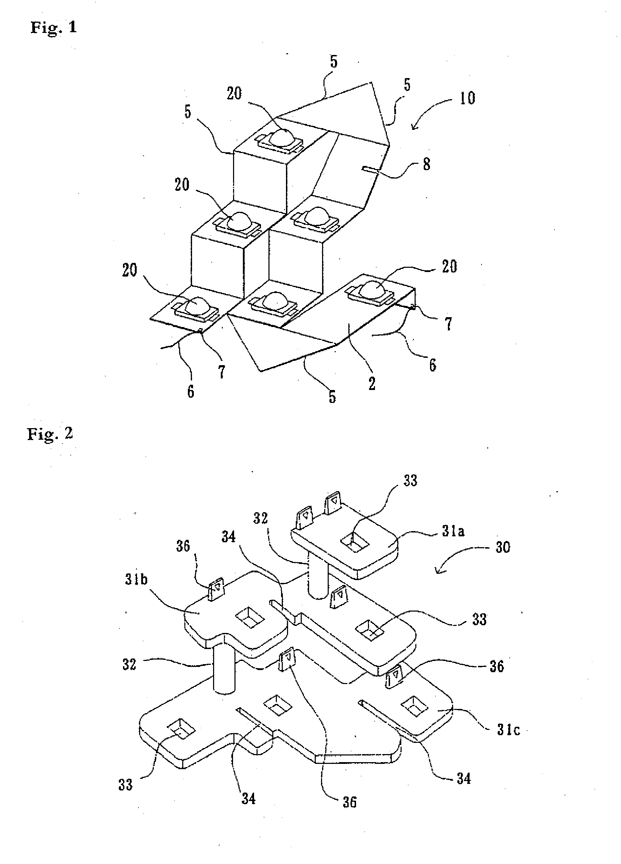

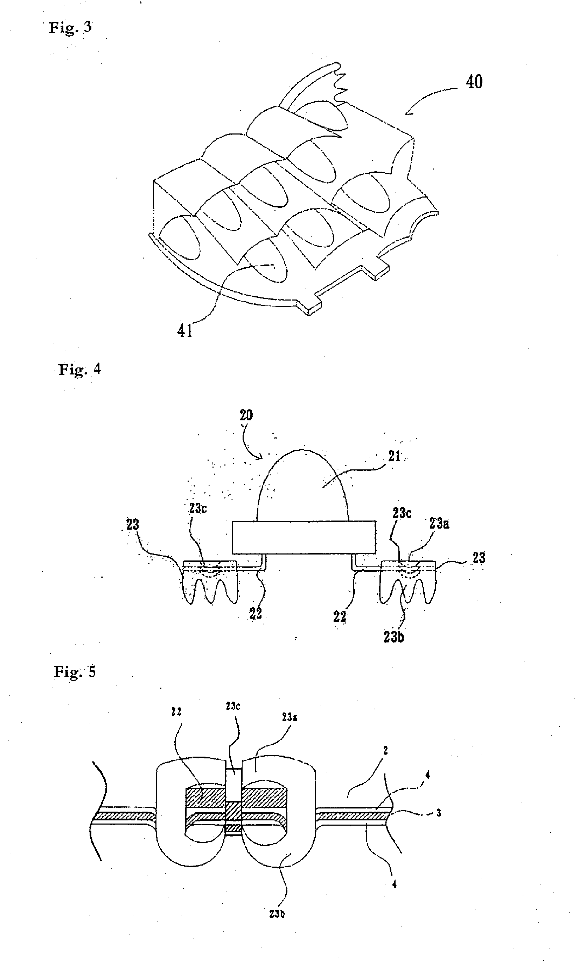

FIG. 1 is a perspective view of a three-dimensional structured flat wiring body 10 which is designed to constitute a three-dimensional, electronic components mounted wiring body according to an embodiment of the present invention. FIGs. 2 and 3 are presented to illustrate an electronic components mounting structure according to the embodiment of the invention. Specifically, FIG. 2 is a perspective view of a base structure 30 assembled from a plurality of base members 31. FIG. 3 is a perspective view of a reflector structure 40 on which is mounted the base structure 30 on which the three-dimensional, electronic components mounted wiring body 10 is mounted.

In the embodiment of the invention, the three-dimensional, electronic components mounted wiring body comprises a flat wiring body 2, on which a plurality of electronic components 20 is mounted, and which is formed with bends and configured into a three-dimensional structured flat wiring body 10,as shown in FIG. 1. The three-dimensional structured flat wiring body 10 is so bent as to fit the shape of a base structure 30, such as the one shown in FIG. 2. The base structure 30 is assembled from, for instance, base members 31a, 31b and 31c, and joining members 32 by joining the base members using the joining members 32.

In the embodiment of the present invention, the electronic components mounting structure is assembled from the three-dimensional structured flat wiring body 10 such as the one shown in FIG. 1 and the base structure 30 such as the one shown in FIG. 2 by mounting the former on the latter. The base structure 30 with the three-dimensional structured flat wiring body 10 mounted thereon may further be mounted on the reflector structure 40 such as the one shown in FIG. 3 to thereby construct an electronic components mounting structure according to an embodiment of the present invention. It is thus noted that an electronic components mounting structure of the invention is constructed from a three-dimensional, electronic components mounted wiring body of the invention and a three-dimensional shaped base structure on which the wiring body is mounted.

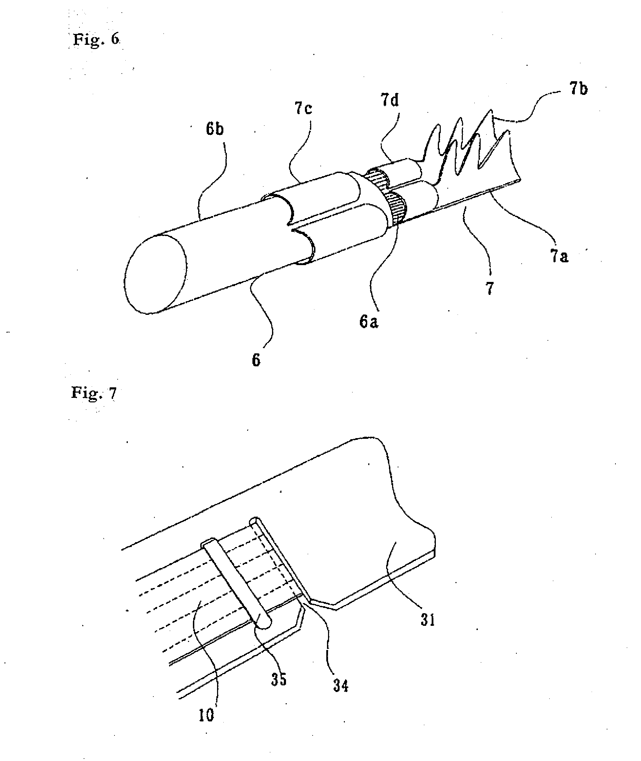

The electronic components 20 mounted on the flat wiring body 2 may comprise light emitting devices 21 such as LEDs each having two leads 22 as shown in FIG. 4. In the illustrated embodiment, each lead 22 is bent in an L-shape plate. The flat wiring body 2 is comprised of a plurality of parallel flat conductors 3, as shown in FIG. 5, which are coated with an insulating coating 4 by gluing or extrusion coating a plastic film (e.g. polyethylene terephthalate film). The flat conductor 3 may be made of a copper tape having thickness of 0.15 mm and width of 5.2 mm, for example. The electronic component 20 is electrically and mechanically connected to the flat wiring body 2 by a connector 23. As shown in FIG. 4, the connector 23 may be comprised of a back plate 23a and a piercing member 23b which is formed below (as seen in FIG. 4) the back plate 23a from both sides thereof. The connector 23 may be made from one metal plate by punching and bending it. The distance between the piercing members 23b of the opposite connectors 23 is chosen such that the leads 22 of the electronic component 20 fit therebetween.

The leads 22 of the electronic component 20 are respectively positioned at the flat conductors 3 of the flat wiring body 2 without stripping the insulating coating 4 from the flat wiring body 2. Each connector 23 is set such that the piercing member 23b is positioned on both sides of the lead 22. The piercing member 23b pierces through a flat conductor 3 of the flat wiring body 2 and is inwardly bent and crimped onto the rear side of the flat wiring body 2 (see FIG. 5) so that the electronic component 20 is electrically and mechanically connected to the flat wiring body 2. This electrical and mechanical connection between the flat wiring body 2 and the electronic component 20 is preferred in terms of operability and quality control since it will not generate a heat as experienced in a soldering or welding process.

It should also be noted that the lead 22 of the electronic component 20 is shear-connected to the back plate 23a of the connector 23 by a shear 23c. This shear connection is made by the shear 23c, which is formed by shearing overlapping portions of the back plate 23a of the connector 23 and the lead 22 in a parallel or generally parallel direction such that the shear 23c is shifted relative to the surrounding portions to form a concave, as shown in FIG. 4. In this way, the lead 22 is firmly connected to the back plate 23a without the use of soldering.

As shown in FIG. 4, the shear 23c may be preformed at the overlapping portions of the lead 22 and the back plate 23a of the connector 23 before urging the piercing member 23b of the connector 23 to pierce through the flat conductor 3 of the flat wiring body 2. In the alternative, the shear 23c may be formed at overlapping portions of three members, i.e. the lead 22, the back plate 23a of the connector 23 and the flat conductor 3 of the flat wiring body 2, as shown in FIG. 5. In the former, the lead 22 of the electronic component 20 will not be shifted relative to the back plate 23a of the connector 23 when the piercing member 23b of the connector 23 is piercing into the flat conductor 3 of the flat wiring body 2. In the latter, the lead 22, the back plate 23a and the flat conductor 3 are firmly connected with one another by the shear without the use of soldering.

The flat wiring body 2 is shaped by bending at positions of bends 5 so as to form a three dimensional structured flat wiring body 10, such as the one shown in FIG. 1.

FIG. 6 shows a perspective view of a feed line 6 and a pierce terminal 7 in FIG. 1. The feed line 6, which is comprised of a conductor 6a and an insulating coating 6b covering the conductor 6a, serves to supply a power or signal to the three-dimensional structured flat wiring body 10. The pierce terminal 7 is designed to provide electrical and mechanical connection between the feed line 6 and the three-dimensional structured flat wiring body 10. As shown in FIG. 6, the pierce terminal 7 is comprised of a rear plate 7a, a piercing member 7b which is formed above the rear plate 7a from the both sides thereof (as seen in FIG. 6), a conductor crimping barrel 7d which is designed to crimp a portion of the conductor 6a where its insulating coating 6b is stripped off, and an insulating barrel 7c which is designed to crimp the feed line 6 having the insulating coating 6b. The piercing member 7b is set to pierce through a flat conductor 3 of the three-dimensional structured flat wiring body 10 at an appropriate point thereof. The piercing member 7b is then inwardly bent on the back side of the flat wiring body 2 and crimped onto the back side so that the three-dimensional structured flat wiring body 10 is electrically and mechanically connected to the feed line 6.

With this electrical and mechanical connection between the three dimensional structured flat wiring body 10 and the feed line 6, there is no need for stripping off the insulating coating 4 of the flat wiring body 2. In addition, this method is preferred in terms of the operability and the quality control since it will not generate a heat during making the connection, which heat is experienced in a soldering or welding process. Moreover, according to this method, any desired point of the three-dimensional structured flat wiring body 10 can be connected to the feed line 6. A reference number 8 denotes a circuit separator which is provided to configure an electric circuit of the three-dimensional structured flat wiring body 10.

In FIG. 2, the base structure 30 is configured with the base members 31a, 31b and 31c which are joined together by the joining members 32. Each base member 31 may be made of hard plastic material such as polybutylene terephthalate (PBT) or metal material such as aluminum alloy. Holes 33 are formed in the base member 31 at appropriate positions. The electronic components 20 mounted on the three-dimensional structured flat wiring body 10 may be fixed or positioned at the holes 33 in such a manner that the light emitting devices 21 such as LEDs are exposed. Slits 34 are also formed in the base member 31. The bends 5 or straight portions of the three dimensional structured flat wiring body 10 are inserted into these slits 34 in order that the three-dimensional structured wiring body 10 is easily fixed to the base members 31.

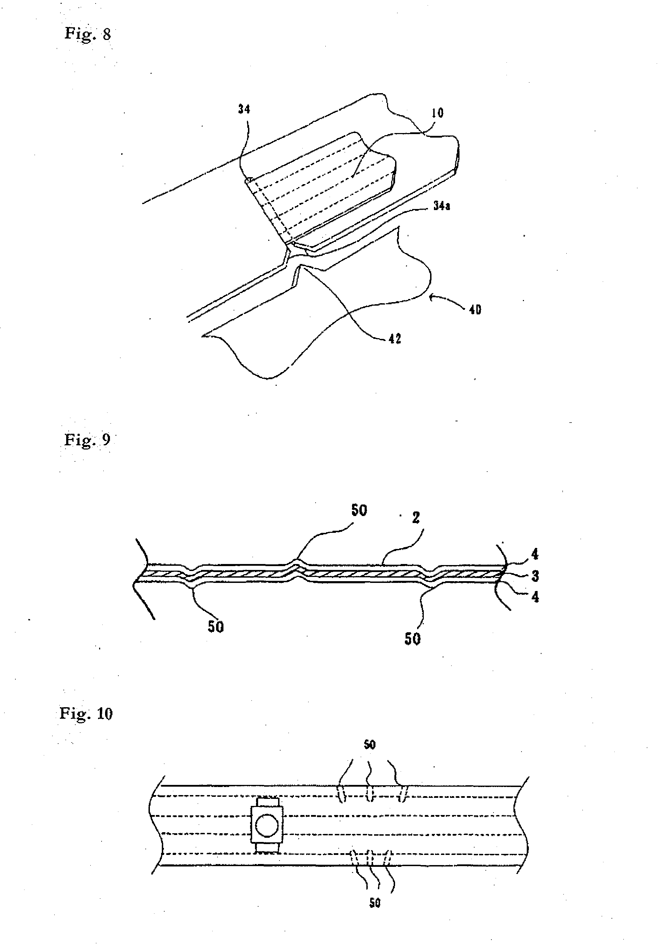

This fixing is carried out using the fixing structure shown in FIG. 7 and/or that shown in FIG. 8. In the fixing structure of FIG. 7, a portion (e.g. bend 5 or straight portion) of the three-dimensional structured flat wiring body 10 is inserted into a slit 34 of the base member 31. A locking member 35 is provided on the back side of the base member 31 to fix the three-dimensional structured flat wiring body 10. In this way, the three-dimensional structured flat wiring body 10 is easily fixed to the base member 31. In the illustrated embodiment, the locking member 35 takes the form of a cantilever so that the three-dimensional structured flat wiring body 10 is held between the locking member 35 and the body of the base member 31. Such a locking member is, however, only illustrative and may be substituted by any suitable means that fixes the three-dimensional structured flat wiring body 10 to the base member 31. For example, claw-like locking members spaced with the distance corresponding to the width of the flat wiring body 2 may be used.

In the fixing structure of FIG. 8, the base member has 31 a cutout 34a such as triangular notch formed in an opening to the slit 34 through which a portion of the three-dimensional structured flat wiring body 10 is inserted. After the portion of the three-dimensional structured flat wiring body 10 is inserted into the slit 34, a protrusion 42 which is formed on the reflector structure 40 and has a shape complementary to the cutout 34a is set to fit the cutout 34a. This prevents the three-dimensional structured flat wiring body 10 from being shifted or slipped out. In addition, the cutout 34a and protrusion 42 may be formed with various shapes depending on fixing positions to facilitate accurate positioning and fixing of the electronic components mounting structure to the reflector structure. It is also noted that the fixing structure of FIG. 7 may be combined with the fixing structure of FIG. 8.

In this way, the three-dimensional structured wiring body 10 is mounted on the base structure 30 shown in FIG. 2 to configure an electronic components mounting structure. This electronic components mounting structure may further be mounted and fixed on the reflector structure 40 in such a manner that the electronic components 20 mounted on the electronic components mounting structure are positioned in inserting holes 41 formed in the reflector structure 40. To this end, it is preferred in terms of operability that a plurality of fitting protrusions 36 is formed on the base structure 30, as shown in FIG. 2, and fit into engaging members (not shown) formed on the reflector structure 40 to thereby simply fix the electronic components mounting structure to the reflector structure 40, rather than using the conventional fitting with a plurality of screws.

Fold lines or creases 50 may advantageously be preformed at bends 5 of the flat wiring body 2 as shown in FIG. 9 so that the flat wiring body 2 can easily be bent just at predetermined positions using the fold lines even if the flat wiring body 2 is thick and hard to be bent.

In the alternative, the fold lines 50 may extend only partially from the side edges of the flat wiring body 2 as shown in FIG. 10. Such incompletely extending fold lines 50 are effective in producing the above mentioned effect. Although the fold lines 50 are preformed on the flat wiring body 2, they may be left as they are without being used to bend the flat wiring body 2 when it is found unnecessary to bend the flat wiring body 2 for the configuration. Thus, the flat wiring body 2 may be preformed with a large number of the fold lines 50 so that a subset of the fold lines is used for the configuration. Specifically, the flat wiring body 2 that may be pre-creased with the fold lines 50 at appropriate positions where the flat wiring body 2 is expected to be bent into bends 5. The flat wiring body pre-creased in this way can flexibly be adapted to the multi-product production and the design change.

Although the present invention has been described with respect to particular embodiments thereof, it is to be understood, of course, that the scope of the present invention should not be limited thereto.

## Claims

1. A Three-dimensional, electronic components mounted wiring body comprising:
a flat wiring body, on which a plurality of electronic components is mounted, and which is preformed with bends to be configured into a three-dimensional structured flat wiring body which fits the shape of a base structure on which the flat wiring body is to be mounted.

2. The three-dimensional, electronic components mounted wiring body according to claim 1, wherein the electronic components comprise light emitting diodes.

3. The three-dimensional, electronic components mounted wiring body according to one of claims 1 and 2, wherein a feed line and a pierce terminal are connected to the flat wiring body at a portion thereof, in which the pierce terminal is designed to electrically and mechanically connect the feed line to the flat wiring body.

4. The three-dimensional, electronic components mounted wiring body according to claim 1, wherein the electronic components are electrically and mechanically connected to the flat wiring body by connectors, each comprising a back plate and a piercing member.

5. The three-dimensional, electronic components mounted wiring body according to claim 4, wherein a lead of the electronic component is connected to the back plate of the connector by shear connection.

6. The three-dimensional, electronic components mounted wiring body according to claim 1, wherein the bends of the flat wiring body to be bent afterward are preformed with fold lines.

7. An electronic components mounting structure comprising:
a flat wiring body, on which a plurality of electronic components is mounted, and which is preformed with bends to be configured into a three-dimensional structured flat wiring body which fits the shape of a base structure for mounting the flat wiring body thereon;
in which the base structure is three-dimensionally assembled from a plurality of base members and their joining members; and
in which the three-dimensional structured flat wiring body is mounted on the base structure.

8. The electronic components mounting structure according to claim 7, wherein holes are formed in the base structure, and the electronic components mounted on the flat wiring body are positioned at these holes.

9. The electronic components mounting structure according to one of claims 7 and 8, wherein the base structure includes a fixing structure which fixes the three-dimensional structured flat wiring body.

10. The electronic components mounting structure according to one of claims 7 to 9, further comprising a reflector structure for mounting the base structure,
wherein at least one of the base structure and the reflector structure includes a fixing structure which is designed to fix the three-dimensional structured flat wiring body mounted on the base structure when the base structure is mounted on the reflector structure.
